# EUROPÄISCHE PATENTANMELDUNG

(11) **EP 4 203 335 A2**
(43) Veröffentlichungstag der Anmeldung: **28.06.2023**
(21) Anmeldenummer: 23158348.5
(22) Anmeldetag: 17.07.2019
(51) Int. Cl.: H04B 7/02, H04B 1/3877, H03F 1/52, H03F 3/189, H03F 3/24, H04B 1/04, H04B 1/18, H04B 1/3822, H04B 1/48, H04B 1/74, H04W 88/08, H04B 1/00

(54) **SENDE-/EMPFANGSSYSTEM FÜR FUNKSIGNALE MIT GETRENNTEN SENDE- UND EMPFANGSPFADEN**

(30) Priorität: 03.08.2018 DE 102018213029
(62) Teilanmeldung aus: 19742343.7
(71) Anmelder: AUDI AG, 85057 Ingolstadt (DE)
(72) Erfinder: Spehl, Jürgen, 85139 Wettstetten (DE); Reichardt, Lars, 85139 Wettstetten (DE); Papp, Aurel, 85123 Karlskron (DE)
(74) Vertreter: RDL Patentanwälte PartG mbB

(57) **Zusammenfassung**

System zum Senden und Empfangen von Funksignalen, welches ein Steuergerät mit einem Modem und einem an das Modem angeschlossenen Sendeverstärkermodul, eine zu dem Steuergerät beabstandet angeordnete Antenneneinheit mit einer Antenne und einem an die Antenne angeschlossenen Empfangsverstärkermodul und ein das Steuergerät und die Antenneneinheit verbindendes Hochfrequenzkabel umfasst. Das System umfasst zudem eine weitere Antenne und ein das mindestens eine Sendeverstärkermodul des Steuergeräts und die weitere Antenne verbindendes weiteres Hochfrequenzkabel. Das System trennt den Empfangspfad von dem Sendepfad, wodurch die Sendeverstärkermodule vor einer Signalreflexion in dem Hochfrequenzkabel geschützt sind. Auf diese Weise wird eine Schädigung oder Zerstörung des Sendeverstärkermoduls oder des Modems effektiv verhindert. Das Sendeverstärkermodul ist bei dem Modem angeordnet und nur das Empfangsverstärkermodul in die Antenneneinheit integriert.

## Beschreibung

Die Erfindung betrifft ein System zum Senden und Empfangen von Funksignalen, welches ein Steuergerät mit einem Modem und einem an das Modem angeschlossenen Sendeverstärkermodul, eine zu dem Steuergerät beabstandet angeordnete Antenneneinheit mit einer Antenne und einem an die Antenne angeschlossenen Empfangsverstärkermodul und ein das Steuergerät und die Antenneneinheit verbindendes Hochfrequenzkabel umfasst.

Bei derartigen Systemen ist das Modem ausgebildet, mittels der Antenne Funksignale zu senden (transmit, TX) und zu empfangen (receive, RX), und wird daher üblicherweise als TRX-Modem bezeichnet. Um hochfrequente (high frequency, HF) Signale zwischen dem Modem und der Antenne zu übertragen, umfasst das System ein Hochfrequenzkabel, durch welches das Modem und die Antenne miteinander verbunden sind.

Allerdings werden die Signale bei der Übertragung in dem Hochfrequenzkabel unvermeidlich gedämpft. Die Dämpfung durch das Kabel, die sogenannte Kabeldämpfung, ist dabei desto stärker, je länger das Hochfrequenzkabel einerseits und je höher die Frequenz der Signale andererseits ist. Infolge der Kabeldämpfung kann die Übertragungsqualität leiden, was beispielsweise zu Bitfehlern führt, die sich im Mobilfunk als Call-Drops bemerkbar machen, und die Reichweite sowie die Empfangsqualität einer Funkverbindung verringert sein. Dennoch ist es häufig wünschenswert oder unumgänglich, das TRX-Modem und die Antenne trotz hoher Signalfrequenzen räumlich beabstandet anzuordnen.

Um in solchen Fällen der Dämpfung der Signale durch das Kabel entgegenzuwirken, werden gewöhnlich Sendeverstärkermodule (power amplifier, PA) und/oder Empfangsverstärkermodule (low noise amplifier, LNA) in den jeweiligen Signalpfad, d.h. Sendepfad bzw. Empfangspfad, eingeschleift. Empfangsverstärkermodule sind zumeist in die Antenneneinheit integriert, um einem Rauschen von empfangenen Signalen entgegenzuwirken, d.h. eine Rauschzahl des Empfangspfads zu verringern. In vielen Fällen sind beispielsweise zugunsten einer einfachen Handhabbarkeit zudem das Empfangsverstärkermodule in die Antenneneinheit integriert.

Die EP 0 905 915 A2 offenbart ein solches als Mobilfunkadapter ausgebildetes System. Der Mobilfunkadapter umfasst eine Antenne und jeweils ein benachbart zu der Antenne angeordnetes und an die Antenne angeschlossenes Empfangsverstärkermodul bzw. Sendeverstärkermodul. Ein zu dem Empfangsverstärkermodul beabstandet angeordnetes mobiles Endgerät, ist an den Mobilfunkadapter über zwei Kabel anschließbar, wobei dem Sendepfad und dem Empfangspfad jeweils eines der beiden Kabel ausschließlich zugeordnet ist.

Ein System der eingangs genannten Art kann insbesondere in einem Fahrzeug, zumeist in einem Kraftfahrzeug, verbaut sein, um dem Fahrzeug eine Funkkommunikation beispielsweise mit einem externen Mobilfunknetz, einem externen WLAN-Zugang, einem externen Bluetooth-Gerät oder mit anderen Fahrzeugen zu ermöglichen (Car2X).

Beispielsweise offenbart die DE 44 10 542 A1 ein System zum Nutzen eines mobilen Endgeräts in einem Fahrzeug. Das System umfasst eine Außenantenne und ein benachbart zu der Außenantenne angeordnetes und an die Außenantenne angeschlossenes Empfangsverstärkermodul und ein innerhalb des Fahrzeugs angeordnetes Sendeverstärkermodul. Das Empfangsverstärkermodul und das Sendeverstärkermodul sind mittels zweier Koaxialkabel miteinander verbunden, die jeweils dem Sendepfad und dem Empfangspfad ausschließlich zugeordnet sind.

Die DE 10 2006 021 514 A1 offenbart ein weiteres Mobilfunkteilnehmersystem für ein Fahrzeug mit einer Antenne, einem benachbart zu der Antenne angeordneten und an die Antenne angeschlossenen Empfangsverstärkermodul, einem Koaxialkabel und einem mit dem Empfangsverstärkermodul über das Koaxialkabel verbundenen Sendeverstärkermodul. Das Koaxialkabel ist zugleich dem Sendepfad und dem Empfangspfad zugeordnet. An das Sendeverstärkermodul ist ein mobiles Endgerät anschließbar.

Wenn die Komponenten eines wie vorstehend beschriebenen Systems nicht ausreichend aufeinander abgestimmt sind, kann die Funktion des Systems beeinträchtigt sein oder das Sendeverstärkungsmodul beispielsweise durch Reflexionen in dem Hochfrequenzkabel beschädigt oder zerstört werden. Eine mangelhafte Abstimmung kann sich leicht aus einer konkreten Einbausituation des Systems, einer fehlerhaften Einstellung der Verstärkermodule oder dergleichen ergeben.

Der Erfindung liegt daher die Aufgabe zugrunde, ein verbessertes System zum Senden und Empfangen von Funksignalen zu schaffen, welches die beschriebenen Nachteile vermeidet und eine große Robustheit aufweist.

Gegenstand der Erfindung ist ferner ein System zum Senden und Empfangen von Funksignalen, welches ein Steuergerät mit einem Modem und mindestens einem an das Modem angeschlossenen Sendeverstärkermodul, mindestens eine zu dem Steuergerät beabstandet angeordnete Antenneneinheit mit einer Antenne und einem an die Antenne angeschlossenen Empfangsverstärkermodul und ein das Modem des Steuergeräts und die mindestens eine Antenneneinheit verbindendes Hochfrequenzkabel umfasst und welches eine weitere Antenne und ein das Sendeverstärkermodul des Steuergeräts und die weitere Antenne verbindendes weiteres Hochfrequenzkabel umfasst. Das System trennt den Empfangspfad von dem Sendepfad, wodurch die Sendeverstärkermodule vor einer Signalreflexion in dem Hochfrequenzkabel geschützt sind. Auf diese Weise wird eine Schädigung oder Zerstörung des Sendeverstärkermoduls oder des Modems effektiv verhindert.

Das Sendeverstärkermodul ist bei dem Modem angeordnet und nur das Empfangsverstärkermodul in die Antenneneinheit integriert. Diese Anordnung bietet den Vorteil, dass das Sendeverstärkermodul und das Modem schaltungstechnisch integriert, d.h. auf derselben Leiterplatte (printed circuit board, PCB) angeordnet, sein können, wobei das Modem die Steuerung des Sendeverstärkermoduls übernimmt. Entsprechend können sonst externe Steuerleitungen zwischen dem Modem und dem Sendeverstärkermodul entfallen. Zudem kann die Sendeleistung des Modems verringert sein, da die von dem Modem gesendeten Signale vor der Übertragung durch das Hochfrequenzkabel von dem Sendeverstärkermodul verstärkt werden.

Bevorzugt ist das System zum Senden und Empfangen von Funksignalen mit einer Frequenz oberhalb von 3 GHz ausgebildet. Bei Frequenzen oberhalb von 3 GHz ist die Dämpfung durch das Hochfrequenzkabel sehr stark. Sowohl Frequenzbänder des Mobilfunks (3,5 GHz) als auch Frequenzbänder für die Car2X-Funkkommunikation (5,9 GHz) liegen oberhalb von 3 GHz.

In einer Ausführungsform ist ein Verstärkungsfaktor des Sendeverstärkermoduls und/oder des Empfangsverstärkermoduls gleich einem oder größer als ein Dämpfungsfaktor des Hochfrequenzkabels, und/oder sind das Sendeverstärkermodul und das Empfangsverstärkermodul symmetrisch dimensioniert. Der Dämpfungsfaktor korrespondiert zu einem Dämpfungsverlust eines Signals in dem Hochfrequenzkabel, also zu einer durch das Kabel verursachten Verlustleistung. Durch eine dem mindestens ebenso großen Verstärkungsfaktor korrespondierende Verstärkungsleistung wird daher die Verlustleistung kompensiert. Die symmetrische Dimensionierung bewirkt eine ausgeglichene Leistungsübertragungsbilanz (link budget) zwischen der Senderichtung und der Empfangsrichtung, was in erster Linie für zertifizierungspflichtige Funkdienste, beispielsweise Bluetooth und Car2X, verlangt wird.

Vorteilhaft umfasst das System ein Stellglied zum insbesondere automatischen Einstellen eines Verstärkungsfaktors des Sendeverstärkermoduls und/oder des Empfangsverstärkermoduls. Das Stellglied kann als eine Software implementiert sein, um den Verstärkungsfaktor flexibel einstellbar vorzusehen. Auf diese Weise ist der Verstärkungsfaktor kodierbar, d.h. die Verstärkungsleistung des Senderverstärkermoduls und/oder des Empfangsverstärkermoduls ist abhängig von der Dämpfung durch das Hochfrequenzkabel einstellbar. Das Stellglied kann ohne oder mit einer Rückmeldung ausgebildet sein. Im letzten Fall kann das Stellglied kann mit einem Detektor, welcher die Dämpfung des Hochleistungskabels erfasst, verbunden sein, um einen Regelkreis für den Verstärkungsfaktor zu bilden. Mittels des Regelkreises wird der Verstärkungsfaktor automatisch und dynamisch an unterschiedliche Längen des Hochleistungskabels angepasst.

Alternativ oder zusätzlich kann das System ein Stellglied zum insbesondere automatischen Einstellen eines nutzbaren Frequenzbereichs umfassen und/oder zum insbesondere automatischen Abstimmen einer Nutzfrequenz ausgebildet sein. Das Stellglied ermöglicht je nach Bandbreite und/oder Anzahl unterstützter Funkdienstkanäle ein Abstimmen, insbesondere Nachregeln (Synchronisieren) des Sendeverstärkermoduls und/oder des Empfangsverstärkermoduls hinsichtlich der jeweils verwendeten Frequenzen (TRX control loop). Das Stellglied kann Teil eines Regelkreises sein, um ein automatisches und dynamisches Abstimmen zu ermöglichen.

In weiteren Ausführungsformen umfasst die Antenneneinheit ein insbesondere skalierbares Hochfrequenzmodul, insbesondere einen Filter, einen Mischer, einen Schalter oder einen Du-/Triplexer. Die Art und Anzahl der Hochfrequenzmodule richtet sich nach der Bandbreite und/oder der Anzahl unterstützter Funkdienstkanäle.

Bei diesen Ausführungsformen kann das Hochfrequenzmodul dem Sendeverstärkermodul und/oder dem Empfangsverstärkermodul in einer Senderichtung und/oder in einer Empfangsrichtung vorgeschaltet sein. Mit anderen Worten kann das Hochfrequenzmodul antennenseitig oder modemseitig in den Sendepfad und/oder in den Empfangspfad eingeschleift sein.

Bevorzugt ist das System zum Senden und Empfangen von Funksignalen unterschiedlicher Funkdienste ausgebildet und umfasst insbesondere die Antenneneinheit einen Kombinierer oder einen Frequenzmultiplexer. Der Kombinierer oder der Frequenzmultiplexer erlauben die Nutzung eines einzigen Hochfrequenzkabels zum gleichzeitigen bzw. parallelen Übertragen von Funksignalen unterschiedlicher Funkdienste, d.h. unterschiedlicher Frequenzen und Bandbreiten (GSM-, UMTS-, LTE-Mobilfunkdienste und Car2X-Dienste).

In einer Ausführungsform umfasst das System eine Diagnoseeinheit zum Prüfen einer Funktionsfähigkeit des Hochfrequenzkabels. Die Diagnoseeinheit kann auf einer Gleichstrom (DC)-Widerstandsmessung beruhen. Alternativ kann die Diagnoseeinheit ein Stromfenster oder ein pulsweitenmoduliertes (pulse width modulation) Signal zu Messzwecken verwenden. Mittels der Diagnoseeinheit kann eine Unterbrechung, ein Kurzschluss oder eine Quetschung des Hochfrequenzkabels auf seiner Einbaustrecke (Fernverbau) zuverlässig erkannt werden.

In weiteren Ausführungsformen ist das System konfiguriert, das Empfangsverstärkermodul über das Hochfrequenzkabel mit einem Gleichstrom zu beaufschlagen, und umfasst insbesondere ein Bias-T (auch als Bias-Tee bezeichnet) und/oder einen Gleichstromblocker (DC blocker). Dies ermöglicht, eine Versorgung der Antenneneinheit durch das Steuergerät, ohne die Antenneneinheit mit einem separaten Stromkabel zu verbinden. Auf diese Weise muss die Antenneneinheit beispielsweise in einem Fahrzeug nicht eigens an das Bordnetz angeschlossen sein.

Die Erfindung ist anhand von Ausführungsformen in den Zeichnungen schematisch dargestellt und wird unter Bezugnahme auf die Zeichnungen weiter beschrieben. Es zeigt:
- Figur 1: in einer schematischen Darstellung ein Blockschaltbild eines Systems zum Senden und Empfangen von Funksignalen;
- Figur 2: in einer schematischen Darstellung ein Blockschaltbild einer Antenneneinheit eines nicht erfindungsgemäßen Systems zum Senden und Empfangen von Funksignalen;
- Figur 3: in einer schematischen Darstellung ein Blockschaltbild einer Antenneneinheit eines weiteren nicht erfindungsgemäßen Systems zum Senden und Empfangen von Funksignalen;
- Figur 4: in einer schematischen Darstellung ein Blockschaltbild einer Antenneneinheit eines dritten nicht erfindungsgemäßen Systems zum Senden und Empfangen von Funksignalen;
- Figur 5: in einer schematischen Darstellung ein Blockschaltbild eines vierten nicht erfindungsgemäßen Systems zum Senden und Empfangen von Funksignalen;
- Figur 6: in einer schematischen Darstellung ein Blockschaltbild eines Systems zum Senden und Empfangen von Funksignalen gemäß einer Ausführungsform der vorliegenden Erfindung.

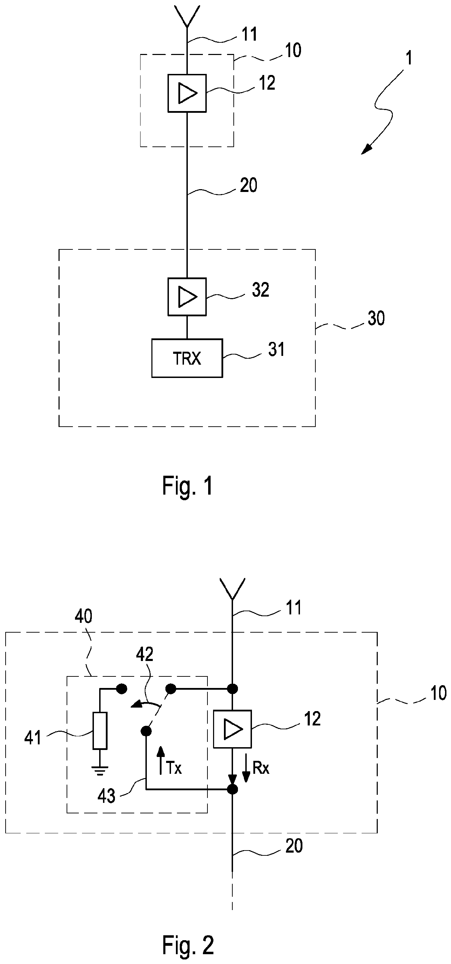

Figur 1 zeigt in einer schematischen Darstellung ein Blockschaltbild eines Systems 1 zum Senden und Empfangen von Funksignalen, das beispielsweise in einem Kraftfahrzeug verbaut ist.

Das System 1 umfasst ein Steuergerät 30 mit einem Modem 31 und einem an das Modem 31 angeschlossenen Sendeverstärkermodul 32, eine zu dem Steuergerät 30 beabstandet angeordnete Antenneneinheit 10 mit einer Antenne 11 und einem an die Antenne 11 angeschlossenen Empfangsverstärkermodul 12 und ein das Steuergerät 30 und die Antenneneinheit 10 verbindendes Hochfrequenzkabel 20. Das System 1 ist zum Senden und Empfangen von Funksignalen mit einer Frequenz oberhalb von 3 GHz ausgebildet ist und ermöglicht entsprechend die Nutzung auch solcher Funkdienste, deren Frequenzbänder hohe Frequenzen aufweisen. Der Sendepfad ist an dem Empfangsverstärkermodul 12, und der Empfangspfad ist an dem Sendeverstärkermodul 32 vorbei geschleift, d.h. das Empfangsverstärkermodul 12 liegt nicht im Sendepfad, und das Sendeverstärkermodul 32 liegt nicht im Empfangspfad.

Figur 2 zeigt in einer schematischen Darstellung ein Blockschaltbild einer Antenneneinheit 10 eines nicht erfindungsgemäßen Systems zum Senden und Empfangen von Funksignalen.

Bei dem System ist ein Verstärkungsfaktor des Sendeverstärkermoduls 32 (s. Figur 1) und/oder des Empfangsverstärkermoduls 12 gleich einem oder größer als ein Dämpfungsfaktor des Hochfrequenzkabels 20. Das Sendeverstärkermodul 32 und das Empfangsverstärkermodul 12 sind überdies symmetrisch dimensioniert.

Das System umfasst ferner eine Diagnoseeinheit (nicht abgebildet) zum Prüfen einer Funktionsfähigkeit des Hochfrequenzkabels 20 und ist ausgebildet, das Empfangsverstärkermodul 12 über das Hochfrequenzkabel 20 mit einem Gleichstrom zu beaufschlagen. Dazu umfasst es ein Bias-T sowie einen Gleichstromblocker (beide nicht abgebildet).

Weiterhin umfasst die Antenneneinheit 10 eine Schutzschaltung 40 (VSWR-Schutzschaltung) zum Schützen des Sendeverstärkermoduls 32 und/oder des Modems 31. Die Schutzschaltung 40 umfasst einen Schutzschalter 42 mit einem Reflexionsleistungsdetektor, einem Abschlusswiderstand 41 und eine Bypass-Leitung 43 und ist konfiguriert, ein Sendesignal mittels der Bypass-Leitung 43 an dem Empfangsverstärkermodul 12 vorbei zu der Antenne 11 oder zu dem Abschlusswiderstand 41 zu leiten, wenn eine von dem Reflexionsleistungsdetektor detektierte Reflexionsleistung einen vorbestimmten Schwellwert überschreitet. Der Schutzschalter 42 kann als ein Halbleiter (HL)-Schalter ausgebildet sein.

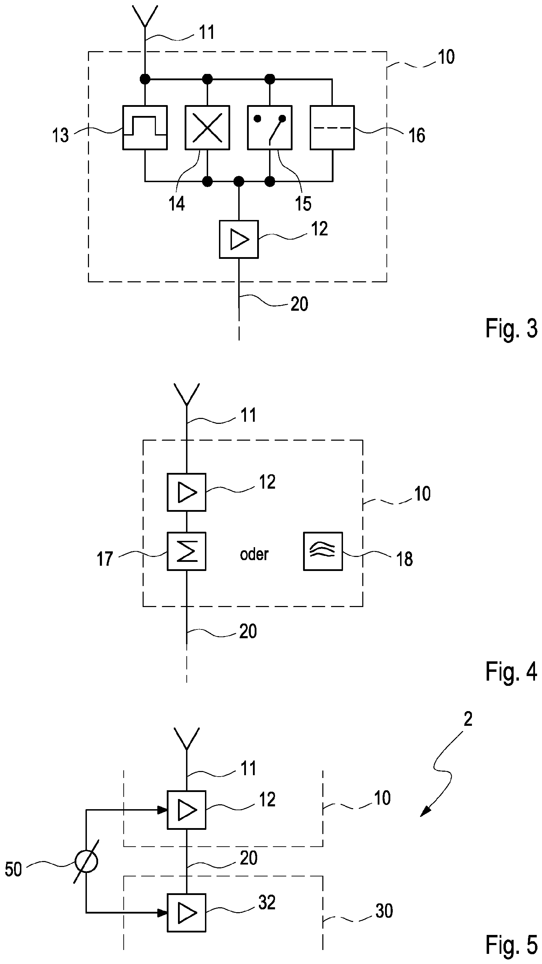

Figur 3 zeigt in einer schematischen Darstellung ein Blockschaltbild einer Antenneneinheit 10 eines weiteren nicht erfindungsgemäßen Systems zum Senden und Empfangen von Funksignalen. Das System hat denselben Aufbau wie das in Figur 2 gezeigte System, wobei die Schutzschaltung 40 der Übersicht halber hier nicht abgebildet ist.

Das System umfasst ein oder mehrere skalierbare Hochfrequenzmodule, die in der Figur 3 lediglich beispielhaft als ein Filter 13, ein Mischer 14, ein Schalter 15 und ein Du-/Triplexer 16 abgebildet sind. Die Hochfrequenzmodule sind zwischen der Antenne 11 und dem Empfangsverstärkermodul 12 eingeschleift und sind dem Empfangsverstärkermodul 12 in einer Empfangsrichtung vorgeschaltet.

Figur 4 zeigt in einer schematischen Darstellung ein Blockschaltbild einer Antenneneinheit 10 eines dritten nicht erfindungsgemäßen Systems zum Senden und Empfangen von Funksignalen. Das System hat denselben Aufbau wie das in Figur 2 gezeigte System, wobei die Schutzschaltung 40 der Übersicht halber hier nicht abgebildet ist.

Das System ist zum Senden und Empfangen von Funksignalen unterschiedlicher Funkdienste (GSM-, UMTS-, LTE-Mobilfunkdienste und Car2X-Dienste) ausgebildet und die Antenneneinheit 10 umfasst einen Kombinierer 17, kann aber auch einen Frequenzmultiplexer 18 umfassen, welcher in der Figur 4 als eine Alternative abgebildet ist.

Figur 5 zeigt in einer schematischen Darstellung ein Blockschaltbild eines vierten nicht erfindungsgemäßen Systems 2 zum Senden und Empfangen von Funksignalen. Das System 2 umfasst ein Stellglied 50 zum automatischen Einstellen eines Verstärkungsfaktors des Sendeverstärkermoduls 32 und des Empfangsverstärkermoduls 12.

Alternativ oder zusätzlich kann das Stellglied 50 auch zum automatischen Einstellen eines nutzbaren Frequenzbereichs oder zum automatischen Abstimmen einer Nutzfrequenz ausgebildet sein.

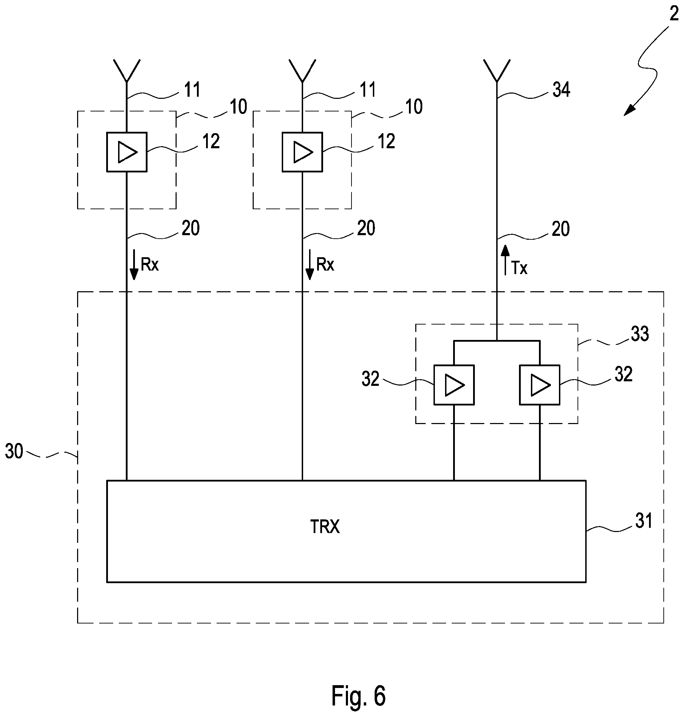

Figur 6 zeigt in einer schematischen Darstellung ein Blockschaltbild eines Systems 2 zum Senden und Empfangen von Funksignalen gemäß einer Ausführungsform der vorliegenden Erfindung. Das System 2 umfasst ein Steuergerät 30 mit einem Modem 31, zwei an das Modem 31 angeschlossenen Sendeverstärkermodulen 32, die zu einer Sendeverstärkereinheit 33 zusammengefasst sind, einer zu dem Steuergerät 30 beabstandeten Antenne 34 und einem die Sendeverstärkermodule 32 des Steuergeräts 30 und die Antenne 34 verbindenden Hochfrequenzkabel 20.

Ferner umfasst das System 2 zwei zu dem Steuergerät 30 beabstandet angeordnete Antenneneinheiten 10 jeweils mit einer Antenne 11 und einem an die Antenne 11 angeschlossenen Empfangsverstärkermodul 12 sowie zwei das Modem 31 des Steuergeräts 30 und die Antenneneinheiten 10 verbindende Hochfrequenzkabel 20. Der Sendepfad mit der Antenne 34 ist vollständig von den beiden Empfangspfaden mit den Antenneneinheiten 10 getrennt, d.h. die Antennen 11 dienen ausschließlich als Empfangsantennen (RX) und die Antenne 34 dient ausschließlich als Sendeantenne (TX).

Ein wesentlicher Vorteil des erfindungsgemäßen Systems 2 zum Senden und Empfangen von Funksignalen besteht darin, dass es bei vielseitiger Verwendbarkeit eine große Robustheit gegenüber unterschiedlichen Einbausituationen und damit Längen des Hochfrequenzkabels 20 aufweist. Weitere Vorteile sind in der einfachen Struktur des Systems 2 und in der Eignung des Systems 2 für hohe Frequenzen der Funksignale zu sehen.

### BEZUGSZEICHENLISTE:

- 1: System
- 2: System
- 10: Antenneneinheit
- 11: Antenne
- 12: Empfangsverstärkermodul
- 13: Filter
- 14: Mischer
- 15: Schalter
- 16: Du-/Triplexer
- 17: Kombinierer
- 18: Frequenzmultiplexer

- 20: Hochfrequenzkabel
- 30: Steuergerät
- 31: Modem
- 32: Sendeverstärkermodul
- 33: Sendeverstärkereinheit
- 34: Antenne
- 40: Schutzschaltung
- 41: Abschlusswiderstand
- 42: Schutzschalter
- 43: Bypass-Leitung
- 50: Stellglied

## Patentansprüche

1. System (2) zum Senden und Empfangen von Funksignalen, welches ein Steuergerät (30) mit einem Modem (31) und mindestens einem an das Modem (31) angeschlossenen Sendeverstärkermodul (32), mindestens eine zu dem Steuergerät (30) beabstandet angeordnete Antenneneinheit (10) mit einer Antenne (11) und einem an die Antenne (11) angeschlossenen Empfangsverstärkermodul (12) und ein das Modem (31) des Steuergeräts (30) und die mindestens eine Antenneneinheit (10) verbindendes Hochfrequenzkabel (20) umfasst und welches eine weitere Antenne (34) und ein das mindestens eine Sendeverstärkermodul (32) des Steuergeräts (30) und die weitere Antenne (34) verbindendes weiteres Hochfrequenzkabel (20) umfasst.

2. System nach Anspruch 1, welches zum Senden und Empfangen von Funksignalen mit einer Frequenz oberhalb von 3 GHz ausgebildet ist.

3. System nach Anspruch 1 oder 2, bei dem ein Verstärkungsfaktor des Sendeverstärkermoduls (32) oder des Empfangsverstärkermoduls (12) gleich einem oder größer als ein Dämpfungsfaktor des Hochfrequenzkabels (20) ist.

4. System nach einem der Ansprüche 1 bis 3, bei dem das Sendeverstärkermodul (32) und das Empfangsverstärkermodul (12) symmetrisch dimensioniert sind.

5. System nach einem der Ansprüche 1 bis 4, welches ein Stellglied (50) zum Einstellen eines Verstärkungsfaktors des Sendeverstärkermoduls (32) oder des Empfangsverstärkermoduls (12) umfasst.

6. System nach einem der Ansprüche 1 bis 5, welches ein Stellglied (50) zum Einstellen eines nutzbaren Frequenzbereichs umfasst oder zum Abstimmen einer Nutzfrequenz ausgebildet ist.

7. System nach einem der Ansprüche 1 bis 6, bei dem die Antenneneinheit (10) ein Hochfrequenzmodul umfasst.

8. System nach Anspruch 7, bei dem das Hochfrequenzmodul als ein Filter (13), ein Mischer (14), ein Schalter (15) oder ein Du-/Triplexer (16) ausgebildet ist.

9. System nach Anspruch 7 oder 8, bei dem das Hochfrequenzmodul dem Sendeverstärkermodul (32) oder dem Empfangsverstärkermodul (12) in einer Senderichtung oder in einer Empfangsrichtung vorgeschaltet ist.

10. System nach einem der Ansprüche 1 bis 9, welches zum Senden und Empfangen von Funksignalen unterschiedlicher Funkdienste ausgebildet ist.

11. System nach Anspruch 10, bei dem die Antenneneinheit (10) einen Kombinierer (17) oder einen Frequenzmultiplexer (18) umfasst.

12. System nach einem der Ansprüche 1 bis 11, welches eine Diagnoseeinheit zum Prüfen einer Funktionsfähigkeit des Hochfrequenzkabels (20) umfasst.

13. System nach einem der Ansprüche 1 bis 12, welches ausgebildet ist, das Empfangsverstärkermodul (12) über das Hochfrequenzkabel (20) mit einem Gleichstrom zu beaufschlagen.

14. System nach Anspruch 13, welches ein Bias-T oder einen Gleichstromblocker umfasst.
